# EUROPEAN PATENT APPLICATION

(11) **EP 3 650 869 A1**
(43) Date of publication of application: **13.05.2020**
(21) Application number: 18380015.0
(22) Date of filing: 12.11.2018
(51) Int. Cl.: G01R 15/20, H02S 40/34

(54) **DEVICE, INSTALLATION AND METHOD FOR MEASURING ELECTRICAL PARAMETERS IN A PHOTOVOLTAIC STRING**

(71) Applicant: Pick Data, S.L., 08232 Viladecavalls (ES)
(72) Inventor: Comellas Cabeza, Joan, 08232 Viladecavalls (ES)
(74) Representative: Sugrañes Patentes y Marcas

(57) **Abstract**

The device (1) for measuring electrical parameters in a photovoltaic string (2) is provided with measuring means (3) for measuring at least one electrical parameter (V, I) of the string, which further comprises inductive means (4) for generating a supply current for the measuring means, and a through hole (5) adapted for the passage of an electrical power cable (6) through the device and through the inductive means for generating the supply current by the induction of a magnetic field induced by the electrical power cable during the passage of an electric current through the electrical cable.

## Description

### Technical field of the invention

The invention presents a device for measuring electrical parameters in a photovoltaic string of a photovoltaic installation of the type for generating an electric current by means of an assembly of photovoltaic panels.

### Background of the invention

To produce electrical energy by means of photovoltaic panels in a photovoltaic installation, groups of panels are arranged in series in a known way to achieve high voltages that can reach up to 1500Vcc, and these groupings of panels arranged in series are known as photovoltaic strings. It is very important to control the performance of each one of the strings, since if one of the panels of the string has a problem, which could be related to filth, a broken panel, etc., given that they are in series, it will affect the performance of the entire string.

To control this performance there are different types of measuring gauges, and the most common ones are the ones that measure current with a Hall effect cell or gauges that take measurements by means of a Shunt resistor. However, since measuring systems work with very high voltages, the power supply system thereof requires a high degree of insulation, of around 4kV, which makes this type of power source more complicated and substantially increases the cost thereof.

It is therefore an object of the present invention to provide a device for measuring electrical parameters in a photovoltaic string of a photovoltaic installation, the power supply system of which has the necessary insulation, and which has a lower cost.

Another object of the present invention is to provide a system and method for measuring electrical parameters of photovoltaic strings that is easy to install and able to measure any number of photovoltaic strings of the installation.

Another object of the present invention is to provide a power supply method.

### Description of the invention

The device for measuring electrical parameters in a string of a photovoltaic installation of the present invention is of the type that comprises measuring means for measuring at least one electrical parameter of the string.

In essence, the device is characterised in that it comprises inductive means for generating a supply current for the measuring means and a through hole, the through hole being adapted for the passage of an electrical power cable through the device, preferably through a casing wherein the power supply means and the measuring means, among others, are housed, and through the inductive means for generating the supply current based on the induction of a magnetic field induced by an electrical power cable during the passage of an electric current through the electrical cable, such that the device can be powered by the magnetic field induced by the external electrical power cable without needing to incorporate an insulated power source, thereby achieving an insulation greater than 4kV. Thus, the electrical power cable will induce a magnetic field corresponding to the passage of electricity through the electrical cable and the induction means will induce an electric current from this magnetic field induced by the electrical cable. Naturally, the supply current must be conveniently regulated to obtain a necessary power voltage, which can be around 5Vcc. It is envisaged that the measuring means comprise, among other known means, a shunt resistor and/or a Hall sensor that allow the voltage and the current of the photovoltaic string to be measured in a known way.

In a variant embodiment, the inductive means are a toroidal coil, through which the electrical cable passes, the toroidal coil being adapted to induce an electric current from the magnetic field induced by the electrical cable, from which the current for powering the device is generated, preferably after being regulated at the desired supply voltage and current. It is envisaged that the coil can be connected to known rectifier and regulating means, among which is a full-wave rectifier that allows for the passage of alternating current induced in the coil to direct current normally used for electronic components. Also, inductive means can incorporate a plurality of toroidal coils or even other types and forms of coils that allow for the passage of the electrical cable therethrough to induce a current, for example coils with a square-shaped core, or other polygonal shapes. It is envisaged that the core is made of iron or ferrite.

Naturally, it is envisaged that the regulating means can incorporate a capacitor that receives the alternating current induced in the coil, which can be previously rectified, such that it allows the current induced in the coil to accumulate until reaching a predetermined threshold, for example in voltage, which allows the capacitor to discharge when reaching the threshold, generating the supply current for the measuring means, carrying out the measurement of the electrical parameter or parameters. The predetermined voltage threshold can be measured by means of known circuits.

In a variant embodiment, the device comprises conductive means to be electrically interconnected in the string, which pass through the device, allowing electrical connection in a photovoltaic string, such that the electric current of the photovoltaic string passes through the device.

In a variant embodiment the conductive means are perpendicular to the through hole, in such a way that several devices can be arranged in parallel in respective photovoltaic strings that are parallel to one another, and the respective through holes thereof can be aligned, thereby facilitating the passage of the electrical power cable and allowing an optimum reduced length of electrical cable to be used. It is further envisaged that the side walls of the device are straight, so that different devices can be applied in parallel to one another.

In a variant embodiment, the device further comprises wireless communication means for transmitting the electrical parameters measured, the wireless communication means being powered by the supply current, and therefore the wireless communication means do not need an insulated power source and can share the power supply means with the measuring means. Naturally, when the regulating means incorporate a capacitor that receives the alternating current induced in the coil, which can be previously rectified, the current induced in the coil will accumulate until reaching a predetermined threshold, for example in voltage, that will allow the capacitor to discharge when reaching the threshold, generating the supply current for the measuring means, such that not only will the electrical parameter or parameters be read, but also the values of the electrical parameter or parameters will be sent by means of the wireless communication means, taking advantage of the current induced and accumulated in the capacitor.

In a variant embodiment, the measuring means are provided with voltage reference means, adapted to connect to at least one element of the photovoltaic installation that has a reference voltage.

Also presented is a photovoltaic installation that comprises at least one string provided with a device for measuring at least one electrical parameter of the string; and a power supply circuit provided with an electrical power cable with an alternating current, which passes through the through hole of the device to generate the supply current of the device, advantageously allowing for the electrical power cable to induce a magnetic field that induces the supply current in the device. Furthermore, it is envisaged that in the case that a greater supply current is necessary, the electrical power cable can pass through the through hole one or several times, forming loops that allow the total magnetic field induced by the power cable to increase.

In a variant embodiment, the installation comprises a plurality of strings parallel with respect to one another, each one of which is provided with a device for measuring at least one electrical parameter of the string, wherein the electrical power cable passes through the through hole of each device to generate the supply current of each device, such that a single electrical power cable allows a magnetic field to be induced that induces the supply current in each device.

In a variant embodiment, the through holes of the devices are aligned, allowing a straight electrical power cable to pass therethrough. Naturally, it is also envisaged that the electrical cable is any other electric conductor that allows an electric current to be conducted, such as a metal rod that can be inserted through the different through holes, which will allow a greater electric current to be conducted and therefore induce a greater magnetic field.

Also disclosed is a method for measuring at least one electrical parameter of a photovoltaic string, which essentially comprises the steps of connecting one of the previously described devices to a photovoltaic string for measuring at least one electrical parameter of the string; and passing an electrical power cable through the through hole of the device, such that during the passage of the electric current through the electrical cable the inductive means of the device generate the supply current from the magnetic field induced by the electrical power cable.

In a variant embodiment, the device being provided with wireless communication means for the electrical parameters measured, and the wireless communication means being powered by the supply current, the method further comprises the step of sending the at least one electrical parameter of the string by means of the wireless communication means.

In a variant embodiment, the device comprises a pair of side walls 14 parallel to one another, through which the through hole passes, normally perpendicularly, such that it is possible to arrange different devices one next to the other, so that the respective through holes are aligned and allow the same electrical power cable to easily pass through all of the devices. Naturally, other forms of side walls are also envisaged, preferably those which allow for a good fit of devices and which allow a channel to be established by means of the different through holes that favour the passage of the same electrical power cable. Additionally, it is envisaged that the device can be provided with coupling means that allow for the consecutive fitting of several devices forming a chain, for example by means of grooves and guides or plug and socket systems, such that the different through holes form a channel through which the electrical power cable can pass. Although the through hole will preferably be straight, it may also be in other forms.

Also disclosed is a method for measuring at least one electrical parameter in each one of a plurality of photovoltaic strings, which essentially comprises the steps of connecting one of the previously described devices in each photovoltaic string to measure at least one electrical parameter of the string; and passing the same electrical power cable through the through hole of the device, such that during the passage of an electric current through the electrical cable the inductive means of each device generate the supply current from the magnetic field induced by the electrical power cable.

In a variant embodiment, each device being provided with wireless communication means for the electrical parameters measured, and the wireless communication means being powered by the supply current, the method further comprises the step of sending each device the at least one electrical parameter of the string by means of the wireless communication means.

Also presented is a method for supplying power to a device for measuring at least one electrical parameter, normally of high or medium voltage, of a photovoltaic string in a photovoltaic installation which comprises using a current induced by a magnetic field, the magnetic field in turn induced by an alternating electric current, normally low voltage, in an electrical cable of the installation, for generating the supply current of the device, thereby typically achieving an insulation greater than 4kV between the high or medium voltage circuit and the low voltage circuit. The method for powering the device using a current induced by a magnetic field in turn induced by an alternating electric current can be done by passing an electrical cable through a through hole of the device which passes through inductive means of the device, thereby passing through the device with the electrical cable, such that during the passage of an alternating electric current through the electrical cable, the inductive means of the device generate the supply current from the magnetic field induced by the electrical power cable.

For powering the device, with the electrical cable of the installation there are different techniques that allow a current to be induced in the device from the passage of a low voltage alternating electric current in the electrical cable of the installation, for example passing or coiling the electrical cable in inductive means, such as a coil of the device, or by the electrical cable having an assembly of inductive patches to be applied against the device such that the magnetic field induced by the patch can be collected by inductive means of the device, which can also be in the form of a patch. However, the method preferably comprises passing the electrical cable through the device, such that it thereby passes through inductive means that allow for optimum use of the magnetic field induced by the electrical cable.

### Brief description of the drawings

As a complement to the description being made, and for the purpose of helping to make the characteristics of the invention more readily understandable, this specification is accompanied by a set of drawings which, by way of illustration and not limitation, represent the following.
Figure 1 shows a device according to the invention;
Figure 2a shows a device according to the invention with the side cover removed;
Figure 2b shows a side view of the device of Figure 2; and
Figure 3 shows a photovoltaic installation with several photovoltaic devices according to the invention.

### Detailed description of the drawings

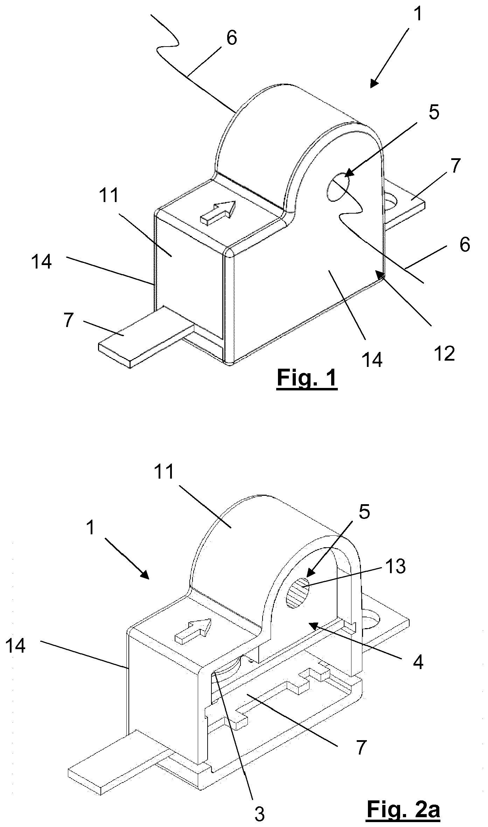

Figure 1 shows a device 1 for measuring electrical parameters in a photovoltaic string 2 according to the present invention. The device 1 is provided with internal measuring means 3 for measuring at least one electrical parameter of the string 2, such as the voltage or the current of the string 2. The device 1 is provided with a casing 11 that protects the internal components, such as the measuring means 3, and is provided with conductive means 7, such as a metal strip, adapted to be electrically connected in the photovoltaic string 2, for example connecting one end of the conductive means 7 to the photovoltaic string 2 and the other end to the connector to which the photovoltaic string 2 would be connected, as will be illustrated further on, or interconnecting the ends of the conductive means 7 in the photovoltaic string 2, for example separating or cutting the string 2 in order to place the device 1. This way, it is envisaged that the device 1 of the present invention can be incorporated in a photovoltaic installation, for example disconnecting a photovoltaic string 2 from a connector and interconnecting the device 1 between the string 2 and the connector, to thus be able to measure, by means of the measuring means 3, the electrical parameters of the string 2. Preferably, the conductive means 7 will be perpendicular to the through hole 5, thereby facilitating the passage of the same electrical power cable 6 through multiple devices 1 arranged in parallel.

It is further observed that the device 1 has a through hole 5 adapted for the passage of an electrical power cable 6 through the device 1. As can be seen, the device 1 comprises a pair of side walls 14, parallel to one another and through which the through hole 5 passes, such that the through hole 5, which in the variant shown is made through the casing 11, allows an electrical power cable 6 to pass through internal inductive means 4 of the device 1, such as a toroidal coil, adapted to generate a supply current for the measuring means 3, as well as for other internal electronic components that need to be insulated, such as wireless communication means 8, adapted to send the measurement obtained by the measuring means 3 to an external reader station 101, such as a computer or mobile telephone device. It is also envisaged that the through hole has a tubular-shaped duct that passes through the inner passage 13 of the inductive means 4, facilitating the passage of the electrical cable 6. Advantageously, since the side walls 14 are parallel to one another and the through hole 5 passes through the same, it is possible to arrange several devices 1 one next to the other, even forming a compact block, so that the different through holes 5 are aligned and it is easy to pass through the different through holes 5 with the same electrical power cable 6.

This way, the inductive means 4 generate the supply current from the magnetic field induced by the electrical cable 6 during the passage of an electric current through the electrical cable 6, which will be an alternating current, for example in a sinusoidal or square form.

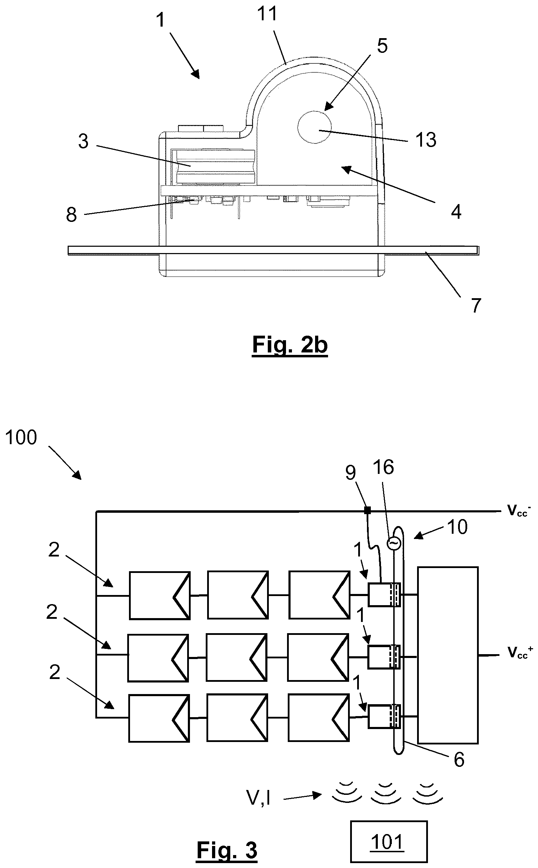

Figures 2a and 2b show the device 1, from which a side cover 12 has been removed from the casing 11. In this figure it can be seen that the inside of the device 1 has the inductive means 4 for generating the supply current for the measuring means 3, arranged so that the through hole 5 passes through the inner passage 13 of the inductive means 4. This way, by introducing the electrical power cable 6 through the through hole 5, the electrical cable 6 passes through the inner passage 13 of the inductive means 4 to generate the supply current from the magnetic field induced by the current that passes through the electrical power cable 6. Naturally, it is envisaged that the inductive means 4 are connected to rectifier means to convert and adapt the alternating electric current induced by the inductive means 4 to the supply current, preferably a direct current. Although in this embodiment the measuring means 3 comprise a shunt resistor, another type of electrical parameter sensors could be used, such as a Hall effect sensor or other known sensors. It is further envisaged that, for example, if one wants to measure the voltage in relation to a reference voltage, the measuring means are provided with voltage reference means 9, such as a cable with a gripper, adapted to connect an element with reference voltage, for example, the reference voltage of the photovoltaic installation V_{cc}-.

Naturally, it is envisaged that the regulating means of the device 1 incorporate a capacitor for receiving alternating current induced in the inductive means 4, which can be previously rectified, which will accumulate the current induced in the coil until reaching a predetermined threshold, for example in voltage, which will allow the capacitor to discharge when reaching the threshold, generating the supply current for the measuring means 3, such that not only the reading of the electrical parameter or parameters V, I is taken, such as the voltage or the current of the photovoltaic string 2, but rather it will advantageously allow the values of the electrical parameter or parameters measured by the powered wireless communication means 8 to be sent, also taking advantage of the current induced and accumulated in the capacitor, thereby sending the reading to a remote receiver or an external reader station 101. This way, it is achieved that by periodically charging and discharging the capacitor, a reading of one or more electrical parameters V, I of the photovoltaic string 2 is measured and sent.

Figure 3 shows an installation 100 that has a plurality of photovoltaic strings, each one of which is provided with a device 1 according to the invention for measuring at least one electrical parameter V, I of the string 2. Moreover, the installation has a power supply circuit 10 provided with an electrical power cable 6, which passes through the device 1, in this case through the through hole 5 of each device 1 to generate the supply current in each device 1. Furthermore, by the through holes of the devices 1 being aligned, not only is it possible to use a shorter electrical cable 6, but it is also easier to pass through the different through holes 5, even if the electrical cable 6 is not flexible.

This way one is able to power the device 1 with a sufficient insulation for measuring at least one electrical parameter V, I of high or medium voltage, of a photovoltaic string 2 in a photovoltaic installation 100 by using a current induced by a magnetic field, the magnetic field in turn being induced by a low-voltage alternating electric current in an electrical cable 6 of the supply current 10 of the installation 100, to generate the supply current of the device 1, the electrical cable 6 passing through the device 1.

It is envisaged that the electric current of the electrical cable 6 can be variable, such that based on the electric current of the electrical cable, the capacitor connected to the inductive means will charge more or less quickly, thereby achieving a greater or lower frequency in the reading of the electrical parameters V, I, and thus a corresponding frequency of these electrical parameters V, I sent to the external reader station 101 or remote receiver. It is envisaged that typically between 1 and 2 amperes pass through the electrical cable 6, inducing a current of a few milliamperes in the inductive means, which are enough to charge the capacitor and power the electronics of the device 1 for measuring and sending the electrical parameters V, I. Naturally, the electronics of the device 1 will be dimensioned for a low consumption, allowing the charging threshold of the capacitor to be adjusted to thereby optimise the charging time, even using a small amount of current in the electric cable 6. It is also envisaged that other electronic components of the device 1 can be powered by the supply current of the device 1.

Thus, to measure at least one electrical parameter V, I of a photovoltaic string 2, it is only necessary to perform the steps of connecting one device 1 to a photovoltaic string 2 in the previously described way to measure at least one electrical parameter of the string; and passing the electrical power cable 6 through the through hole 5 of the device, such that during the passage of the electric current through the electrical cable 6 the inductive means 4 of the device 1 generate the supply current from the magnetic field induced by the electrical power cable 6.

It is also envisaged that when the device 1 is provided with wireless communication means 8 for the electrical parameters V, I measured, the wireless communication means 8 also advantageously being powered by the supply current, it further comprises the step of sending the at least one electrical parameter V, I of the string 2 measured by means of the wireless communication means 8. Naturally, it is also envisaged that the communication of the electrical parameters V, I measured can be done in other ways, such as through luminous or audible signals, or the device 1 can even be provided with a screen. It is even envisaged that the communication of the electrical parameters V, I measured can be carried out, for example, by inducing, or injecting, a signal in the electrical power cable 6 with the value of the electrical parameters V, I measured and optionally other data such as an identifier of the device 1. In this case, the power supply circuit 10 must be prepared to filter and recover this signal, sending it, for example, to a reader station 101. Even the communications could be able to be carried out by cable, for example a network cable, as long as the electronics of the communication are sufficiently insulated from the photovoltaic string 2.

This way, when one desires to measure at least one electrical parameter V, I in each one of the strings 2 of a plurality of photovoltaic strings 2, such as in the installation 100 illustrated in Fig. 3, it is only necessary to connect one device 1 in each photovoltaic string 2 in the previously described way in order to measure at least one electrical parameter V, I of the string 2; and to pass the electrical power cable 6, which can be the same electrical cable 6 for all of the devices 1, through the through hole 5 of each device 1, such that during the passage of an electric current through the electrical cable 6 the inductive means 4 of each device generate the supply current from the magnetic field induced by the electrical power cable 6. Although Fig. 3 shows a single power supply circuit 10 provided with a single electrical power cable 6, it is envisaged that for larger installations several power supply circuits can be used, each one provided with an electrical cable 6, so that the devices 1 can be powered in groups. When these devices are further provided with wireless communication means 8 for the electrical parameters V, I measured, powered by the supply current, it will also be possible to send each device the at least one electrical parameter V, I measured of the string 2 by means of the wireless communication means 8.

Advantageously, if one desires to incorporate new strings 2 in the installation 100 and measure the electrical parameters V, I thereof, or measure other strings 2 that were not previously measured, it is only necessary to incorporate a device 1 between the string 2 and the connector thereof, and pass the electrical power cable 6 through the through hole 5 thereof, for example disconnecting the electrical cable 6 and opening the power supply circuit 10 and, after passing the electrical cable 6 through the through hole 5, closing the power supply circuit 10 once again, and thus the device 1 will also be powered by the induced current. This way, it is possible to increase or reduce the number of photovoltaic strings 2 of an installation 100 without needing to modify the power supply circuit 10. Naturally, it is envisaged that the power supply circuit 10 has a generator 16, generally powered by a power outlet at 220V, in which the current can be regulated in a known way, such that the current generated which passes through the electrical power cable 6 can be adjusted, which in the embodiment shown is connected to the two poles of the generator closing a circuit, so that it is the current or intensity needed based on the number of devices 1 to power. Furthermore, since the devices 1 are provided with wireless communication means 8, such as a communication system by radiofrequency, such as Bluetooth or Wi-Fi, the measurements obtained by the measuring means 3 of each device 1 can be sent to a reader station 101, such as a computer or mobile telephone, remotely and without the need to access the installation 100.

## Claims

1. A device (1) for measuring electrical parameters in a photovoltaic string (2) provided with measuring means (3) for measuring at least one electrical parameter (V, I) of the string, **characterised in that** it further comprises inductive means (4) for generating a supply current for the measuring means, and a through hole (5) adapted for the passage of an electrical cable (6) through the device and through the inductive means for generating the supply current from the induction of a magnetic field induced by the electrical power cable during the passage of an electric current through the electrical cable.

2. The device (1) according to the preceding claim, **characterised in that** it comprises conductive means (7) for electrically connecting to the string (2) which pass through the device.

3. The device (1) according to the preceding claim, **characterised in that** the conductive means (7) are perpendicular to the through hole (5).

4. The device (1) according to any one of the preceding claims, **characterised in that** it further comprises wireless communication means (8) for at least one electrical parameter (V, I) measured, powered by the supply current.

5. The device (1) according to any one of the preceding claims, **characterised in that** the measuring means (3) are provided with voltage reference means (9), adapted to be connected to an element with reference voltage.

6. The device (1) according to any one of the preceding claims, **characterised in that** it comprises a pair of side walls (14) parallel to one another through which the through hole (5) passes.

7. A photovoltaic installation (100) **characterised in that** it comprises at least one photovoltaic string (2) provided with a device (1) according to any one of the preceding claims for measuring at least one electrical parameter (V, I) of the string; and a power supply circuit (10) provided with an electrical power cable (6) with an alternating current, which passes through the through hole (5) of the device for generating the supply current of the device.

8. The installation (100) according to the preceding claim, **characterised in that** it comprises a plurality of photovoltaic strings (2), each one of which is provided with a device according to any one of the claims 1 to 6 for measuring at least one electrical parameter (V, I) of the string, wherein the electrical cable (6) passes through the through hole (5) of each device to generate the supply current of each device.

9. The photovoltaic installation (100) according to the preceding claim, **characterised in that** the through holes (5) of the devices (1) are aligned.

10. A method for measuring at least one electrical parameter (V, I) of a photovoltaic string (2), **characterised in that** it comprises the steps of:
- connecting a device (1) according to any one of claims 1 to 6 to a photovoltaic string for measuring at least one electrical parameter of the string; and
- passing an electrical cable (6) through the through hole (5), such that during the passage of an electric current through the electrical cable the inductive means (4) of the device generate the supply current from the magnetic field induced by the electrical power cable.

11. The method according to the preceding claim, **characterised in that**, with the device (1) being provided with wireless communication means (8) for at least one electrical parameter (V, I) measured, and the wireless communication means powered by the supply current, it further comprises the step of
- sending the at least one electrical parameter (V, I) measured of the string (2) by means of the wireless communication means.

12. The method for measuring at least one electrical parameter (V, I) in each one of a plurality of photovoltaic strings (2), **characterised in that** it comprises the steps of:
- connecting a device (1) according to any one of claims 1 to 6 in each photovoltaic string to measure at least one electrical parameter (V, I) of the string; and
- passing the same electrical cable (6) through the through hole (5) of each device, such that during the passage of an electric current through the electrical cable the inductive means (4) of each device generate the supply current from the magnetic field induced by the electrical power cable.

13. The method according to the preceding claim, **characterised in that**, with each device (1) being provided with wireless communication means (8) for at least one electrical parameter (V, I) measured, and the wireless communication means being powered by the supply current, it further comprises the step of
- sending each device the at least one electrical parameter (V, I) measured of the string (2) by means of the wireless communication means.

14. The method for powering a device (1) for measuring at least one electrical parameter (V, I) of a photovoltaic string (2) in a photovoltaic installation (100) which comprises using a current induced by a magnetic field, the magnetic field in turn being induced by an alternating electric current in an electrical cable (6) of the installation, to generate the supply current of the device.

15. The method according to the preceding claim, **characterised in that** it comprises passing the electrical cable (6) through the device (1).
